# EUROPEAN PATENT APPLICATION

(11) **EP 4 845 368 A1**
(43) Date of publication of application: **25.11.2026**
(21) Application number: 24963074.0
(22) Date of filing: 13.12.2024
(51) Int. Cl.: H10K 59/38

(54) **DISPLAY PANEL AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Daxing District Beijing 100176 (CN)
(72) Inventor: LU, Yuqun, Beijing 100176 (CN); LI, Zeliang, Beijing 100176 (CN); GAO, Tao, Beijing 100176 (CN)
(74) Representative: Durán-Corretjer, S.L.P.
(86) International application number: PCT/CN2024/139320
(87) International publication number: WO 2026/123367

(57) **Abstract**

Embodiments of the present application provide a display panel and a display device. The display panel comprises a substrate, a light-emitting structure layer, a color conversion layer and a reflective layer. The light-emitting structure layer is located on a side of the substrate, and the light-emitting structure layer comprises a plurality of light-emitting units arranged at intervals. The color conversion layer is located on the side of the light-emitting structure layer away from the substrate. The color conversion layer comprises a plurality of color conversion portions arranged at intervals, and the orthographic projection of each color conversion portion on the substrate covers the orthographic projection of one of the light-emitting units corresponding thereto on the substrate. The reflective layer is located on a same side of the light-emitting structure layer as the color conversion layer and comprises a plurality of reflecting elements. Each reflecting element is disposed corresponding to one of the light-emitting units, and the extension direction of the reflecting element intersects the extension direction of a plane in which the substrate is located. At least part of light emitted by a light-emitting unit is emitted to a reflecting element corresponding thereto, and is reflected to a color conversion portion corresponding to the light-emitting unit. Thus, the utilization rate of light can be improved.

## Description

### TECHNICAL FIELD

The present disclosure relates to the field of display technology, and in particular to a display panel and a display device.

### BACKGROUND

A luminescent principle of a display panel including a color conversion layer is that light-emitting devices of a single color are used as a backlight to excite a color conversion material in the color conversion layer to emit light of a different color. For example, the light-emitting device may be a blue organic light-emitting device, the color conversion material includes a photochromic quantum dot material, and light emitted by the blue organic light-emitting device is converted by the color conversion layer to obtain light of a different color, thereby realizing a full-color display.

### SUMMARY OF THE INVENTION

The embodiments of the present disclosure provide a display panel, including:
a substrate;
a luminescent structure layer arranged on one side of the substrate and including a plurality of light-emitting units arranged at intervals;
a color conversion layer arranged on a side of the luminescent structure layer away from the substrate and including a plurality of color conversion portions arranged at intervals, with an orthographic projection of each color conversion portion on the substrate covering an orthographic projection of a corresponding light-emitting unit of the plurality of light-emitting units on the substrate; and
a reflective layer on a same side of the luminescent structure layer as the color conversion layer and including a plurality of reflective elements, wherein each reflective element is arranged corresponding to one light-emitting unit, an extending direction of each reflective element intersects an extending direction of a plane where the substrate is located, and at least part of light emitted by each light-emitting unit is irradiated to the corresponding reflective element and reflected to the color conversion portion corresponding to the light-emitting unit.

In some embodiments, the display panel further includes: a dam layer, wherein the dam layer and the reflective layer are located on the same side of the luminescent structure layer, the dam layer includes a plurality of dam patterns and a plurality of first openings defined by the plurality of dam patterns and arranged at intervals, each first opening is filled with at least a portion of one color conversion portion, the plurality of dam patterns are further provided with a plurality of second openings, each second opening is located between two adjacent first openings, a cross section of each second opening of the plurality of dam patterns has an inverted trapezoid shape in a direction from the substrate to the luminescent structure layer, and each reflective element is located on sidewalls of the dam pattern and the second opening corresponding to the reflective element.

In some embodiments, a region enclosed by an orthographic projection of each reflective element on the substrate covers an orthographic projection of the corresponding light-emitting unit on the substrate, and the orthographic projection of each reflective element on the substrate has a ring shape.

In some embodiments, the luminescent structure layer further includes a pixel defining layer, the pixel defining layer is provided with a plurality of pixel openings, each light-emitting unit is located in the corresponding pixel opening, and an orthographic projection of a surface of each first opening close to the substrate on the substrate covers an orthographic projection of an opening surface of the corresponding pixel opening away from the substrate on the substrate.

In some embodiments, the display panel further includes an inorganic encapsulation layer and an organic material layer sequentially stacked on a side of the reflective layer away from the substrate, and the organic material layer is made of at least one of a light-transmitting material and a light-shielding material.

In some embodiments, the display panel further includes: a dam layer, wherein the dam layer and the reflective layer are located on the same side of the luminescent structure layer, the dam layer includes a plurality of dam patterns and a plurality of first openings defined by the plurality of dam patterns and arranged at intervals, each first opening is filled with at least a portion of one color conversion portion, a cross section of each first opening has a trapezoid shape in a direction from the substrate to the luminescent structure layer, and each reflective element is arranged on a sidewall of the corresponding first opening.

In some embodiments, each reflective element is in contact with the corresponding color conversion portion.

In some embodiments, an orthographic projection of a surface of each first opening close to the substrate on the substrate covers an orthographic projection of the corresponding light-emitting unit on the substrate, a region enclosed by an orthographic projection of each reflective element on the substrate covers an orthographic projection of the corresponding light-emitting unit on the substrate, and the orthographic projection of each reflective element on the substrate has a ring shape.

In some embodiments, each first opening penetrates through the dam layer, and the dam layer is made of at least one of a light-shielding material and a light-transmitting material; or
a depth of each first opening is smaller than a thickness of the dam layer in the direction from the substrate to the luminescent structure layer, and the dam layer is made of the light-transmitting material.

In some embodiments, the display panel further includes an encapsulation layer located on a side of the luminescent structure layer away from the substrate, the encapsulation layer includes an organic encapsulation layer, and the organic encapsulation layer is further used as the dam layer.

In some embodiments, the display panel further includes an encapsulation layer located on a side of the luminescent structure layer away from the substrate, the encapsulation layer includes an organic encapsulation layer, and the reflective layer is located in the organic encapsulation layer.

In some embodiments, the organic encapsulation layer includes a first organic encapsulation layer located on a side of the luminescent structure layer away from the substrate, the first organic encapsulation layer is provided with a plurality of first protrusions arranged at intervals, and an orthographic projection of each first protrusion on the substrate covers an orthographic projection of one color conversion portion on the substrate; a cross section of each first protrusion is gradually reduced in a direction from the substrate to the luminescent structure layer, and the cross section is perpendicular to a surface of the substrate close to the luminescent structure layer; and each reflective element is arranged on a sidewall of the corresponding first protrusion.

In some embodiments, an orthographic projection of a surface, close to the substrate, of each first protrusion on the substrate covers an orthographic projection of the corresponding light-emitting unit on the substrate, a region enclosed by an orthographic projection of each reflective element on the substrate covers an orthographic projection of the corresponding light-emitting unit on the substrate, and the orthographic projection of each reflective element on the substrate has a ring shape.

In some embodiments, the display panel further includes a second organic encapsulation layer on a side of the first organic encapsulation layer away from the substrate, and a surface of each color conversion portion close to the substrate is in contact with the first organic encapsulation layer or the second organic encapsulation layer.

In some embodiments, the display panel further includes a second organic encapsulation layer on the same side of the luminescent structure layer as the first organic encapsulation layer, and a first inorganic encapsulation layer on a side of the organic encapsulation layer close to the substrate, and the second organic encapsulation layer is in contact with the first inorganic encapsulation layer.

In some embodiments, the first organic encapsulation layer includes a recess, an orthographic projection of the recess on the substrate does not overlap with an orthographic projection of each first protrusion on the substrate, the display panel further includes a first light-blocking layer located on a side of the first organic encapsulation layer away from the substrate, and at least a portion of the first light-blocking layer is located within the recess.

In some embodiments, the display panel further includes: a first inorganic encapsulation layer on a side of the organic encapsulation layer close to the substrate, wherein the first light-blocking layer is in contact with the first inorganic encapsulation layer.

In some embodiments, the organic encapsulation layer includes a first organic encapsulation layer located on a side of the luminescent structure layer away from the substrate, the first organic encapsulation layer is provided with a plurality of third openings arranged at intervals, and an orthographic projection of each third opening on the substrate covers an orthographic projection of one color conversion portion on the substrate; and a cross section of each third opening has a trapezoid shape in a direction from the substrate to the luminescent structure layer, and each reflective element is arranged on a sidewall of the corresponding third opening.

In some embodiments, an orthographic projection of each third opening on the substrate covers an orthographic projection of the corresponding light-emitting unit on the substrate, a region enclosed by an orthographic projection of each reflective element on the substrate covers an orthographic projection of the corresponding light-emitting unit on the substrate, and the orthographic projection of each reflective element on the substrate has a ring shape.

In some embodiments, the display panel further includes a second organic encapsulation layer located on a side of the first organic encapsulation layer away from the substrate, and a first light-blocking layer disposed on a side of the organic encapsulation layer away from the substrate, and a surface of the first light-blocking layer close to the substrate is in contact with the first organic encapsulation layer or the second organic encapsulation layer.

In some embodiments, each reflective element is made of a metal.

In some embodiments, each reflective element includes a reflective surface close to one side of the corresponding light-emitting unit, and an angle between the reflective surface and a light-outgoing surface of the corresponding light-emitting unit is less than 90°.

In some embodiments, each reflective element includes a reflective surface close to one side of the corresponding light-emitting unit, and an angle between the reflective surface and a light-outgoing surface of the corresponding light-emitting unit is greater than or equal to 45°.

In some embodiments, at least one of the plurality of color conversion portions includes quantum dots and scatters.

The present disclosure further provides a display device which includes the display panel.

The beneficial effect of present disclosure includes:
In the present disclosure, the reflective layer is provided on a side of the luminescent structure layer close to the color conversion layer, so that a part of light with a large viewing angle emitted by the luminescent structure layer is irradiated onto the corresponding reflective elements and is converted into reflected light, which is then reflected by the reflective layer to the color conversion portions corresponding to the light-emitting units. Therefore, more light is incident on the color conversion portions, which can excite a color conversion material in the color conversion portions with a higher probability, thereby improving the color conversion efficiency of the color conversion portions and increasing the utilization efficiency of the light emitted by the luminescent structure layer.

Additional aspects and advantages of the present disclosure will be set forth in part in the following description and will be obvious from the description, or may be learned by practice of the present disclosure.

### BRIEF DESCRIPTION OF THE DRAWINGS

The accompanying drawings, which are incorporated in the present disclosure and constitute a part of the present disclosure, illustrate embodiments consistent with the present disclosure, and together with the description, serve to explain the principles of the present disclosure.
FIG. 1 is a schematic cross-sectional view of a structure of a display panel in the related art;
FIG. 2 is a schematic top view of a structure of a display panel according to an . exemplary embodiment of the present disclosure;
FIG. 3 is a schematic cross-sectional view of the display panel of FIG. 2 taken along a section line PP according to an exemplary embodiment of the present disclosure;
FIG. 4 is a schematic diagram of a stacked structure of a luminescent layer according to an exemplary embodiment of the present disclosure;
FIG. 5 is a schematic top view of a structure of a part of layers of a first pixel PX1 of the display panel in FIG. 3 according to an exemplary embodiment of the present disclosure; and
FIGS. 6 to 20 each are a schematic cross-sectional view of the display panel shown in FIG. 2 taken along a section line PP according to an exemplary embodiment of the present disclosure.

In the drawings: 10-Substrate; 20-Driving circuit layer; 21-Thin film transistor; 211-Active layer; 212-Gate electrode; 213-First pole; 214-Second pole; 22-Capacitor; 221-First plate; 222-Second plate; 23-Light-shielding layer; 24-First insulating layer; 25-Second insulating layer; 26-Third insulating layer; 27-Interlayer dielectric layer; 28-First planarization layer; 30-Luminescent structure layer; 31-Pixel defining layer; 31a-Pixel opening; 32a-First light-emitting unit (light-emitting unit); 32b-Second light-emitting unit (light-emitting unit); 32c-Third light-emitting unit (light-emitting unit); 321-First electrode; 322-Luminescent layer; 323-Second electrode; 33-Spacer; 40-Encapsulation layer; 41-First inorganic encapsulation layer; 42-Organic encapsulation layer; 421-First organic encapsulation layer; 4211-First protrusion; 4212-Recess; 4213-Third opening; 422-Second organic encapsulation layer; 43-Second inorganic encapsulation layer; 50-First light-blocking layer; 51-Organic material layer; 60-Color conversion layer; 601-Color conversion portion; 601a-First color conversion portion; 601b-Second color conversion portion; 601c-Light-transmission portion; 61-Dam layer; 610-Dam pattern; 61a-First opening; 61b-Second opening; 62-Reflective layer; 621-Reflective element; 621a-First reflective element; 621b-Second reflective element; 621c-Third reflective element; 71-Third inorganic encapsulation layer; 72-Second planarization layer; 81-Second light-blocking layer; 82-Color filter layer; 82a, 82b and 82c-Color filter portion; and 90-Third planarization layer.

### DETAIL DESCRIPTION OF THE EMBODIMENTS

The present disclosure will be described more fully hereinafter with reference to the accompanying drawings in which embodiments are shown.

It should be noted that when a component A such as a layer, film, or region is referred to as being "on a side of a component B away from a component C", it means that the component A may be directly on a surface of the component B away from the component C, or that an intermediate layer, intermediate region, or intermediate component may alternatively be present between the component B and the component A. When the component A such as a layer, film, region is referred to as being "between the component B and the component C", it means that only the component A is present between the component B and the component C, or that an intermediate layer, intermediate region, or intermediate component may alternatively be present between the component A and the component B, and between the component A and the component C.

Although terms such as "first", "second", and the like may be used to describe various components, these components are not limited by the above terms. These terms are only used to distinguish one component from another component, and are not to be construed as indicating or implying relative importance or implicitly indicating the number of technical features indicated. Therefore, a feature defined with "first", "second", or the like may explicitly or implicitly include one or more of the features. In the description of the present disclosure, the term "a plurality of" means two or more unless otherwise specified. The features of the following embodiments of the present disclosure may complement or be combined with each other without conflict.

In the drawings, symbols "x", "y", and "z" are used to indicate directions, and x, y, and z directions are not limited to three directions perpendicular to each other in a rectangular coordinate system and may be interpreted in a broader sense. For example, the x direction, the y direction, and the z direction may be perpendicular to each other, or may represent different directions that are not perpendicular to each other. Exemplarily, the x direction is used to indicate a first direction, the y direction is used to indicate a second direction perpendicular to the first direction, and the z direction is used to indicate a third direction perpendicular to the first direction and the second direction. The first direction x, the second direction y, and the third direction z may correspond to a horizontal direction, a vertical direction, and a thickness direction of a display panel, respectively.

In the drawings, a size and a thickness of a component may be exaggerated for better understanding, clarity and ease of description. However, the present disclosure is not limited to the size and the thickness shown in the drawings. In the drawings, a thickness of a layer, a film, panel, a region, and the like may be exaggerated for clarity. Exemplary embodiments are illustrated in the accompanying drawings in which like reference numerals refer to like components.

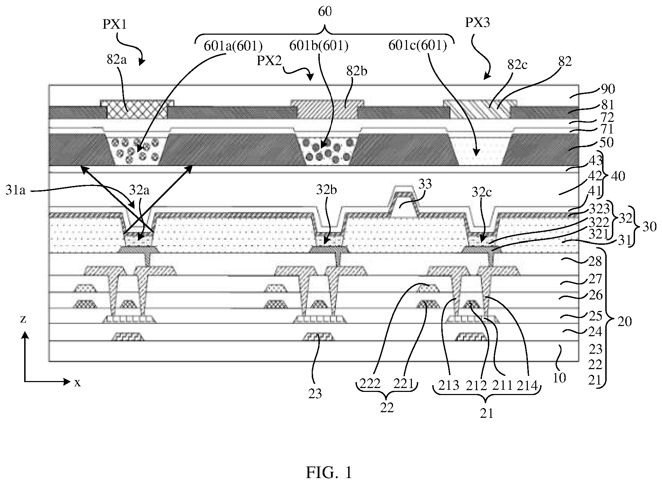

In a photo-luminescent quantum dot organic light-emitting device, as shown in FIG. 1, adjacent color conversion portions 601 in a color conversion layer 60 in a display panel are separated from each other by a first light-blocking layer 50, the first light-blocking layer 50 is usually made of a black material, and therefore, has the low light transmittance, and a part of light with a large viewing angle emitted by a luminescent structure layer 30 is irradiated onto the first light-blocking layer 50, and may be absorbed by the first light-blocking layer 50, so that a part of light cannot be irradiated onto the color conversion portions 601 for utilization, and thus the color conversion portions 601 have the low color conversion efficiency, and the low light outgoing efficiency.

The present disclosure provides a display panel and a display device, and aims to solve or eliminate the technical problems as described above.

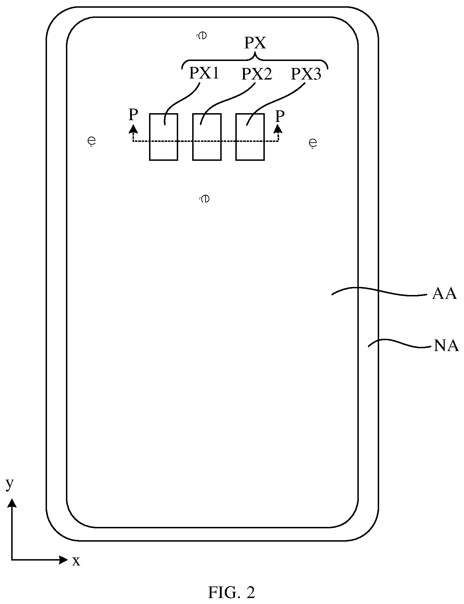

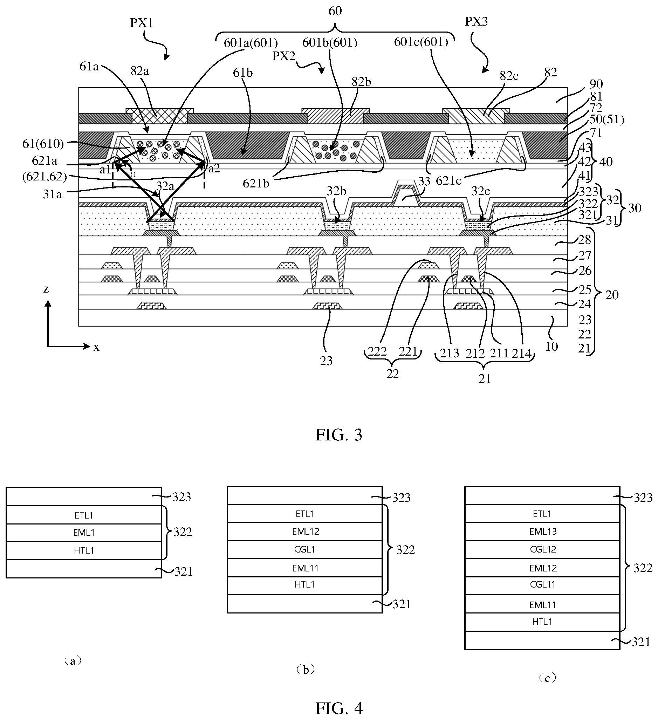

As shown in FIG. 2, FIG. 2 is a schematic top view of a structure of a display panel. The display panel may include a display region AA and a non-display region NA located outside the display region AA. The display panel is provided with an array of a plurality of pixels PX arranged in an array in the display region AA to provide an image. The pixels PX may include a first pixel PX1, a second pixel PX2, and a third pixel PX3. As shown in any one of FIGS. 3 to 18, any one of FIGS. 3 to 18 is a schematic cross-sectional view taken along a sectional line PP in FIG. 1. The display panel includes a substrate 10, a luminescent structure layer 30, a color conversion layer 60, and a reflective layer 62. The luminescent structure layer 30 is located on one side of the substrate 10, and includes a plurality of light-emitting units 32a, 32b and 32c arranged at intervals. The color conversion layer 60 is located on a side of the luminescent structure layer 30 away from the substrate 10, and includes a plurality of color conversion portions 601 arranged at intervals, and an orthographic projection of each color conversion portion 601 on the substrate 10 covers an orthographic projection of a corresponding one of the light-emitting units 32a, 32b and 32c on the substrate 10. The reflective layer 62 and the color conversion layer 60 are located on the same side of the luminescent structure layer 30, and the reflective layer 62 includes a plurality of reflective elements 621, each reflective element 621 is disposed corresponding to one of the light-emitting units 32a, 32b, and 32c, an extending direction of the reflective element 621 intersects an extending direction of a plane where the substrate 10 is located, and at least a part of the light emitted by each of the light-emitting units 32a, 32b, and 32c is emitted toward the corresponding reflective element 621, and is reflected to the corresponding color conversion portion 601.

In the present disclosure, the reflective layer 62 is provided on a side of the luminescent structure layer 30 close to the color conversion layer 60, so that a part of light with a large viewing angle emitted by the luminescent structure layer 30 is irradiated onto the corresponding reflective elements 621 and is converted into reflected light, which is then reflected by the reflective layer 62 to the color conversion portions 601 corresponding to the light-emitting units 32a, 32b, and 32c. Therefore, more light is incident on the color conversion portions 601, which can excite a color conversion material in the color conversion portions 601 with a higher probability, thereby improving the color conversion efficiency of the color conversion portions 601 and enhancing the utilization efficiency of the light emitted by the luminescent structure layer 30.

In some embodiments, the light-emitting units 32a, 32b, and 32c of the luminescent structure layer 30 include a first light-emitting unit 32a, a second light-emitting unit 32b, and a third light-emitting unit 32c. The color conversion portions 601 of the color conversion layer 60 include a first color conversion portion 601a, a second color conversion portion 601b, and a light-transmission portion 601c. An orthographic projection of the first color conversion portion 601a on the substrate 10 covers an orthographic projection of the corresponding first light-emitting unit 32a on the substrate 10, an orthographic projection of the second color conversion portion 601b on the substrate 10 covers an orthographic projection of the corresponding second light-emitting unit 32b on the substrate 10, and an orthographic projection of the light-transmission portion 601c on the substrate 10 covers an orthographic projection of the corresponding third light-emitting unit 32c on the substrate 10.

In some embodiments, the first light-emitting unit 32a, the second light-emitting unit 32b and the third light-emitting unit 32c each emit light of a third color, the first color conversion portion 601a and the second color conversion portion 601b each include quantum dots and scatters, the first color conversion portion 601a in the color conversion layer 60 may convert light of the third color emitted from the corresponding first light-emitting unit 32a in the luminescent structure layer 30 into light of a first color to be emitted out, the second color conversion portion 601b in the color conversion layer 60 may convert light of the third color emitted from the corresponding second light-emitting unit 32b in the luminescent structure layer 30 into light of a second color to be emitted out, and the light-transmission portion 601c in the color conversion layer 60 may transmit light of the third color emitted from the corresponding third light-emitting unit 32c in the luminescent structure layer 30 to be emitted out. In one example, the first color is red, the second color is green, and the third color is blue.

In some embodiments, the reflective layer 62 includes a first reflective element 621a, a second reflective element 621b, and a third reflective element 621c. The first reflective element 621a is disposed corresponding to the first light-emitting unit 32a, and is configured to receive the light with a large viewing angle emitted by the first light-emitting unit 32a and reflect the light to the first color conversion portion 601a. The second reflective element 621b is disposed corresponding to the second light-emitting unit 32b, and is configured to receive the light with a large viewing angle emitted by the second light-emitting unit 32b and reflect the light to the second color conversion portion 601b. The third reflective element 621c is disposed corresponding to the third light-emitting unit 32c, and is configured to receive the light with a large viewing angle emitted by the third light-emitting unit 32c and reflect the light to the light-transmission portion 601c. It should be noted that the first reflective element 621a and the second reflective element 621b may be respectively disposed only at positions corresponding to the first color conversion portion 601a and the second color conversion portion 601b according to actual needs in the present disclosure, so as to reduce the material cost

In some embodiments, the extending direction of the reflective element 621 intersects the extending direction of the plane where the substrate is located, and the plane where the substrate is located may be understood as a plane of a surface of the substrate close to the luminescent structure layer, that is, a light-outgoing surface of each of the light-emitting units 32a, 32b and 32c. Exemplarily, as shown in FIG. 3, an angle α is formed between the extending direction of the reflective element 621 and the light-outgoing surface of a corresponding one of the light-emitting units 32a, 32b and 32c, and the angle α is not equal to 0. Preferably, the angle α is less than 90°.

In some embodiments, the reflective element 621 is made of metal. Illustratively, the reflective element 621 may be made of aluminum (Al), silver (Ag), gold (Au), copper (Cu), titanium (Ti), chromium (Cr), nickel (Ni), or any other metal having a reflective function, and may have a single-layer structure or a multi-layer structure. In one example, the reflective element 621 has a structure of Ti-Al-Ti metals stacked.

In some embodiments, the substrate 10 may be a flexible substrate or a rigid substrate. The flexible substrate may be made of one or more of polyimide, polyethylene terephthalate, polycarbonate, and an organic resin material, and the organic resin material may include epoxy, triazine, silicone, polyimide, or the like. The rigid substrate for example may include any one of a glass substrate, a quartz substrate, a sapphire substrate, and the like.

In some embodiments, each light-emitting unit 32 includes a first electrode 321, a luminescent layer 322 on a side of the first electrode 321 away from the substrate 10, and a second electrode 323 on a side of the luminescent layer 322 away from the substrate 10. One of the first electrode 321 and the second electrode 323 is an anode, and the other is a cathode. In the drawings, the first electrode 321 is an anode, the second electrode 323 is a cathode, the cathode is a common electrode, and the cathodes of all the light-emitting units are connected together to form a planar electrode. In some embodiments, the luminescent layer 322 is an organic luminescent layer, and the light emitted from each light-emitting unit may be blue light or green light.

In some embodiments, the luminescent layer 322 may be shaped as a continuous film. The luminescent layer 322 may include a plurality of layers that may be stacked together. In some embodiments, as shown in part (a) of FIG. 4, the luminescent layer 322 may include a first hole transport layer HTL1 located on the first electrode 321, a first luminescent material layer EML1 located on the first hole transport layer HTL1, and a first electron transport layer ETL1 located on the first luminescent material layer EML1. The first luminescent material layer EML1 may be a blue luminescent layer. In other embodiments, as shown in part (b) of FIG. 4, the luminescent layer may further include a first charge generation layer CGL1 located on the first luminescent material layer EML11 and a second luminescent material layer EML12 located on the first charge generation layer CGL1, in addition to the first hole transport layer HTL1, the first luminescent material layer EML11, and the first electron transport layer ETL1. The first electron transport layer ETL1 may be located on the second luminescent material layer EML12. Similar to the first luminescent material layer EML11, the second luminescent material layer EML12 may emit blue light. The second luminescent material layer EML12 may emit blue light having the same peak wavelength as the first luminescent material layer EML11 or a different peak wavelength from the first luminescent material layer EML11. The first luminescent material layer EML11 and the second luminescent material layer EML12 may emit light of different colors. For example, the first luminescent material layer EML11 may emit blue light, and the second luminescent material layer EML12 may emit green light. In further embodiments, as shown in part (c) of FIG. 4, the luminescent layer may further include a second charge generation layer CGL12 located on the second luminescent material layer EML12 and a third luminescent material layer EML13 located on the second charge generation layer CGL12 in addition to the first hole transport layer HTL1, the first luminescent material layer EML11, the first charge generation layer CGL11, the second luminescent material layer EML12, and the first electron transport layer ETL1. The third luminescent material layer EML13 may emit blue light having the same peak wavelength as the first luminescent material layer EML11 and the second luminescent material layer EML12 or a different peak wavelength from the first luminescent material layer EML11 and the second luminescent material layer EML12. The first luminescent material layer EML11, the second luminescent material layer EML12, and the third luminescent material layer EML13 may emit light of the same color or different colors. For example, the first luminescent material layer EML11 may emit blue light, and the second luminescent material layer EML12 may emit green light and the third luminescent material layer EML13 may emit blue light. The structure with two or more luminescent material layers can improve luminescent efficiency and lifespan of the light-emitting units. The number of the luminescent material layers may be set as desired by one of ordinary skill in the art, and the present disclosure is not limited thereto.

In some embodiments, as shown in FIG. 3, the display panel further includes a driving circuit layer 20 between the substrate 10 and the luminescent structure layer 30. The driving circuit layer 20 includes a plurality of pixel circuits configured to drive the light-emitting units 32. The pixel circuits may be arranged in one-to-one correspondence with the light-emitting units 32, and each pixel circuit is configured to drive its corresponding light-emitting unit 32.

In some embodiments, each pixel circuit may include a thin film transistor 21 and a capacitor 22. The thin film transistor 21 may include an active layer 211, a gate electrode 212, a first pole 213, and a second pole 214. One of the first pole 213 and the second pole 214 is a source electrode and the other is a drain electrode. The capacitor 22 includes a first plate 221 and a second plate 222 disposed opposite to each other. The pixel circuit layer may further include a plurality of signal lines, such as scan signal lines, data signal lines, power signal lines, and the like (not shown).

In some embodiments, the gate electrode 212 and the first plate 221 of the capacitor 22 are located in the same layer, the second plate 222 of the capacitor 22 is located on a side of the first plate 221 away from the substrate 10, and the first pole 213 and the second pole 214 of the thin film transistor 21 are located in the same layer and on a side of the second plate 222 away from the substrate 10. The driving circuit layer 20 further includes a second insulating layer 25 between the active layer 211 and the gate electrode 212, a third insulating layer 26 between the gate electrode 212 and the second plate 222, an interlayer dielectric layer 27 between the second plate 222 and the first pole 213, and a first planarization layer 28 between the first pole 213 and the first electrode 321. The first electrode 321 is electrically connected to the second pole 214 through a hole penetrating through the first planarization layer 28, and the first pole 213 and the second pole 214 are in contact with the active layer 211 through holes penetrating through the interlayer dielectric layer 27, the third insulating layer 26, and the second insulating layer 25, respectively.

It should be noted that a top gate type thin film transistor in this embodiment is taken as an exemplary embodiment. The thin film transistor 21 in the present disclosure may be alternatively a bottom gate type thin film transistor or a double gate type thin film transistor.

In some embodiments, the display panel further includes a light-shielding layer 23 arranged on a side of the substrate 10 close to the thin film transistor 21, and the light-shielding layer 23 can prevent external ambient light from reaching the active layer 211 of the thin film transistor 21, thereby preventing the active layer 211 from being degraded. A material of the light-shielding layer 23 may include a metal such as copper (Cu), aluminum (Al), molybdenum (Mo), titanium (Ti), or tungsten (W), and may have a single-layer structure or a multi-layer structure.

In some embodiments, the display panel further includes a first insulating layer 24 between the light-shielding layer 23 and the active layer 211 to avoid the direct contact between the light-shielding layer 23 and the active layer 211

In some embodiments, the display panel further includes a buffer layer (not shown), which may be arranged between the substrate 10 and the light-shielding layer 23, and a surface of the substrate 10 close to the thin film transistor 21 may be subjected to a planarization process to relieve the stress generated on the active layer 211 and improve the structural stability.

In some embodiments, a third planarization layer 90 is further arranged on a side of a color filter layer 82 away from the substrate 10.

In some embodiments, the luminescent structure layer 30 further includes a pixel defining layer 31, and the pixel defining layer 31 is provided with a plurality of pixel openings 31a. The pixel defining layer 31 is located on a side of the first electrode 321 away from the substrate 10. The pixel openings 31a may be one-to-one correspondence with the light-emitting units 32a, 32b, and 32c, and each pixel opening 31a exposes at least a portion of the corresponding first electrode 321. At least a part of the light-emitting layer 322 of each of the light-emitting units 32a, 32b, 32c is located within the pixel opening 31a. The second electrode 323 is at least partially located on a side of the pixel defining layer 31 away from the substrate 10. Each pixel opening 31a defines a light-emitting region of the corresponding one of the light-emitting units 32a, 32b, 32c, and specifically, a region defined by a bottom surface of the pixel opening 31a close to the substrate 10 is the light-emitting region of the corresponding one of the light-emitting units 32a, 32b, 32c.

In some embodiments, the display panel further includes a spacer 33 disposed on a side of the pixel defining layer 31 away from the substrate 10 for improving a supporting force of the display panel. In some embodiments, the spacer 33 may alternatively be omitted.

In some embodiments, as shown in FIG. 3, the display panel further includes an encapsulation layer 40 located on a side of the luminescent structure layer 30 away from the substrate 10. Further, the encapsulation layer 40 may include a first inorganic encapsulation layer 41, an organic encapsulation layer 42, and a second inorganic encapsulation layer 43, which are stacked together.

In some embodiments, as shown in FIG. 3, the display panel further includes a dam layer 61, the dam layer 61 and the reflective layer 62 are located on the same side of the luminescent structure layer 30, the dam layer 61 is provided with a plurality of dam patterns 610 and a plurality of first openings 61a defined by the dam patterns 610 and arranged at intervals, each first opening 61a is filled with at least a portion of one color conversion portion 601, the plurality of dam pattern 610 are further provided with a plurality of second openings 61b each located between two adjacent first openings 61a, a cross section of each second opening 61b of the dam pattern 610 has an inverted trapezoid shape in a direction from the substrate 10 to the luminescent structure layer 30, and each reflective element 621 is located on sidewalls of the dam pattern 610 and the second opening 61b corresponding to the reflective element 621.

Further, each color conversion portion 610 is in direct contact with the second inorganic encapsulation layer 43 of the encapsulation layers 40, which is farthest from the substrate 10.

In this embodiment, the second opening 61b is disposed so that the plurality of reflective elements 621 in the reflective layer 62 cover the sidewalls of the dam patterns 610 and the second openings 61b, thereby enabling the light with a large viewing angle emitted by the light-emitting units 32a, 32b, and 32c in the luminescent structure layer 30 to be reflected by the reflective elements 621 and then to be incident into the color conversion layer 60, further increasing the probability that the color conversion material in the color conversion layer 60 is excited, and improving the color conversion efficiency, so as to further improve the light utilization efficiency.

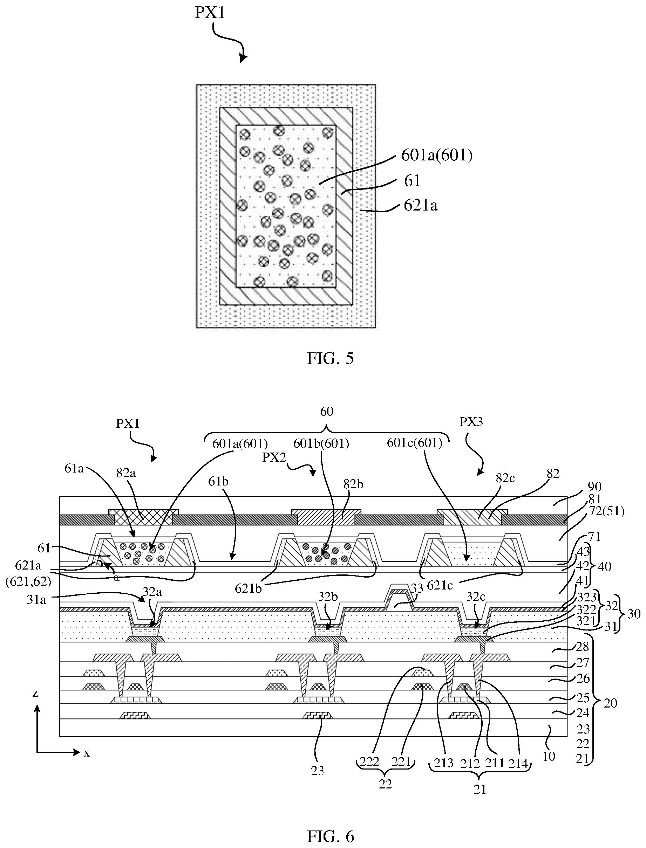

In some embodiments, a region enclosed by an orthographic projection of each reflective element 621 on the substrate 10 covers an orthographic projection of the corresponding one of the light-emitting units 32a, 32b and 32c on the substrate 10, and the orthographic projection of each reflective element 621 on the substrate 10 has a ring shape. For example, as shown in FIG. 5, a region enclosed by an orthographic projection of the first reflective element 621a on the substrate 10 covers the corresponding first light-emitting unit 32a, so that it may further realize that a region covered by the light of the light-emitting unit emitted to a surface of the dam layer 61 close to the substrate 10 falls into the region enclosed by the orthographic projection of the reflective element 621a on the substrate 10. The light emitted from the light-emitting unit 32a may be fully reflected by the reflective element 621a and then be incident into the corresponding first color conversion portion 601a for use. In some embodiments, as shown in FIG. 3, two intersection points a1 and a2 on the cross-sectional view of a surface of the second inorganic encapsulation layer 43 away from the substrate 10, where the light with the maximum angle emitted by the first light-emitting unit 32a is incident, are boundary points of the two second openings 61b on both sides of the first opening 61a corresponding to the first light-emitting unit 32a, which are close to the first light-emitting unit 32a on the cross section.

In some embodiments, as shown in FIG. 3, an orthographic projection of a surface of the first opening 61a close to the substrate 10 on the substrate 10 covers an orthographic projection of an opening surface of the corresponding pixel opening 31a away from the substrate 10 on the substrate 10. Therefore, the first opening 61a may sufficiently receive the light emitted from each of the light-emitting units 32a, 32b, and 32c and convert the light incident into the color conversion portion 601 into the corresponding desired emitted light.

In some embodiments, a third inorganic encapsulation layer 71 is further provided on a side of the color conversion layer 60 away from the substrate 10. The third inorganic encapsulation layer 71 is configured to isolate the color conversion portions 601 from the external environment and protect the color conversion portions 601. In some examples, as shown in FIG. 3, the third inorganic encapsulation layer 71 is disposed on a side of the reflective layer 62 away from the substrate. In other examples, the third inorganic encapsulation layer 71 is disposed between the reflective layer 62 and the color conversion layer 60 (not shown).

In some embodiments, as shown in FIG. 3 or FIG. 6, an organic material layer 51, a second planarization layer 72, a second light-blocking layer 81, and a color filter layer 82 are sequentially provided on a side of the third inorganic encapsulation layer 71 away from the substrate 10, the color filter layer 82 includes a plurality of color filter portions 82a, 82b, and 82c arranged at intervals, the second light-blocking layer 81 is provided with a plurality of light-shielding openings, each light-shielding opening is configured to accommodate at least a part of a corresponding one of the color filter portions 82a, 82b, and 82c, and an orthographic projection of each of the color filter portions 82a, 82b, and 82c on the substrate 10 covers an orthographic projection of the corresponding one of the light-emitting units 32a, 32b, and 32c on the substrate 10. The color filter layer 82 may further filter the light being incident on the color filter layer 82 so that light of a corresponding color is emitted out, so as to avoid interference between light of different wavelengths.

In some embodiments, as shown in FIG. 3, the organic material layer 51 may be made of a light-shielding material. The light-shielding material may be a polymer material doped with black pigments or particles. Illustratively, the organic material layer 51 may be further used as the first light-blocking layer 50.

In some embodiments, as shown in FIG. 6, a material of the organic material layer 51 may be a light-transmitting material. The light-transmitting material may include an organic material such as acryl, benzocyclobutene (BCB), or hexamethyldisiloxane (HMDSO). Illustratively, the organic material layer 51 may be further used as the second planarization layer 72.

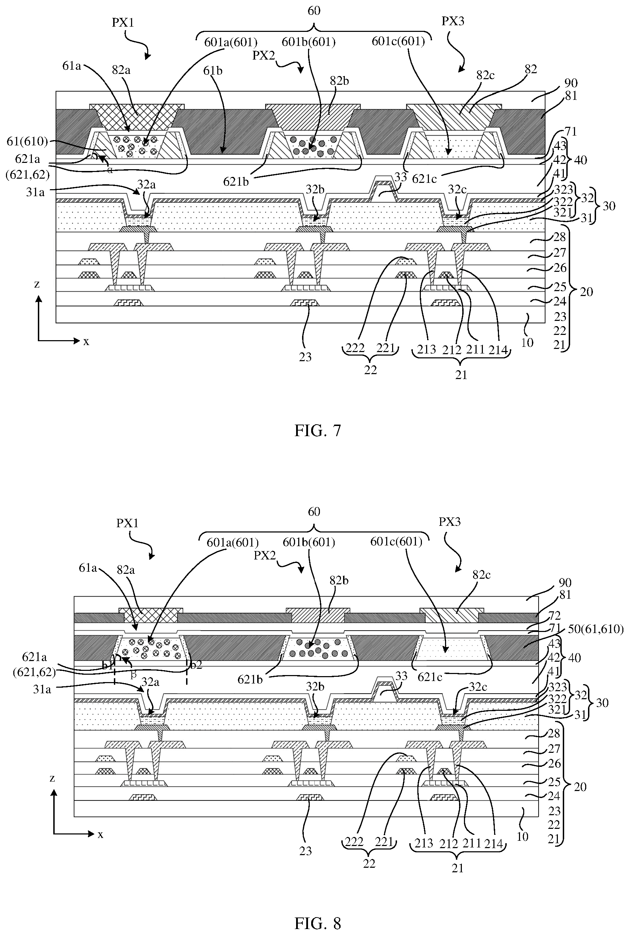

In some embodiments, as shown in FIG. 7, the second light-blocking layer 81 and the color filter layer 82 are sequentially provided on a side of the third inorganic encapsulation layer 71 away from the substrate 10. At least part of the second light-blocking layer 81 is filled in the second opening 61b, and the color filter layer 82 directly covers a surface, corresponding to a region where each color conversion portion 601 is located, of the third inorganic encapsulation layer 71 away from the substrate 10. In this embodiment, the second light-blocking layer 81 and the color filter layer 82 are directly arranged on a surface of the third inorganic encapsulation layer 71 away from the substrate 10, and the second planarization layer 72 or the first light-blocking layer 50 is not required to be included, so that the number of masks used in the manufacturing procedure can be further reduced, and the manufacturing procedure can be simplified.

In some embodiments, as shown in any one of FIGS. 3, 6 and 7, a smaller angle α of inclination angles of sidewalls of the second openings 61b is greater than or equal to 45° and less than 90°, that is, the reflective element 621 is provided with a reflective surface close to one side of the corresponding one of the light-emitting units 32a, 32b and 32c, and an angle between the reflective surface and a light-outgoing surface of the corresponding one of the light-emitting units 32a, 32b and 32c is greater than or equal to 45° and less than 90°. Therefore, the reflected light is more easily emitted into the color conversion portions 601 to excite more quantum dots, and the color conversion efficiency and the light utilization efficiency are improved.

In some embodiments, as shown in any one of FIGS. 8 to 10, the dam layer 61 and the reflective layer 62 are arranged on a same side of the luminescent structure layer 30, the dam layer 61 includes the plurality of dam patterns 610 and the plurality of first openings 61a defined by the dam patterns 610 and arranged at intervals, each of the first openings 61a is filled with at least a portion of one of the color conversion portions 610, a cross section of each first opening 61a has a trapezoid shape in a direction from the substrate 10 to the luminescent structure layer 30, and the reflective element 621 is disposed on a sidewall of the first opening 61a.

In this embodiment, by directly forming the plurality of first openings 61a with the cross section having the trapezoid shape, and directly forming the reflective element 621 on the sidewall of each first opening 61a, the sidewall of the first opening 61a of the dam layer 61 in this embodiment may be used as a carrying structure for forming the reflective element 621, so that the reflective element 621 is attached to the sidewall of the first opening 61a. The first opening 61a may be formed by using exposure and development processes, so that the first opening 61a has such the shape. The reflective element 621 may be formed by a photolithography process, which may specifically include depositing a thin film and then performing a patterning process by etching to form the reflective element 621.

In some embodiments, after the reflective element 621 is formed on the sidewall of the first opening 61a, the corresponding color conversion portion 601 may be continuously filled in each first opening 61a, and the color conversion portion 601 is in direct contact with the reflective element 621. The first opening 61a in this embodiment may be configured to be filled with the color conversion portion 601, and the reflective element may be directly formed on the sidewall of the first opening 61a, which omits the step of forming the second opening 61b in the previous embodiments, thereby further simplifying the manufacturing process and improving the manufacturing efficiency.

In some embodiments, an orthographic projection of a surface of the first opening 61a close to the substrate 10 on the substrate 10 covers an orthographic projection of the corresponding one of the light-emitting units 32a, 32b, and 32c on the substrate 10, and an orthographic projection of the reflective element 621 on the substrate 10 has a ring shape. For example, as shown in FIG. 6, similarly to the previous embodiments, in this embodiment, two intersection points b1 and b2 on the cross-sectional view of a surface of the second inorganic encapsulation layer 43 away from the substrate 10, where the light with the maximum angle emitted by the first light-emitting unit 32a is incident, are two boundary points of the first opening corresponding to the first light-emitting unit 32a on the cross section.

In some embodiments, as shown in FIG. 8, the first opening 61a penetrates through the dam layer 61, and a material of the dam layer 61 includes a light-shielding material. Crosstalk of adjacent light can be further avoided by the light-shielding material.

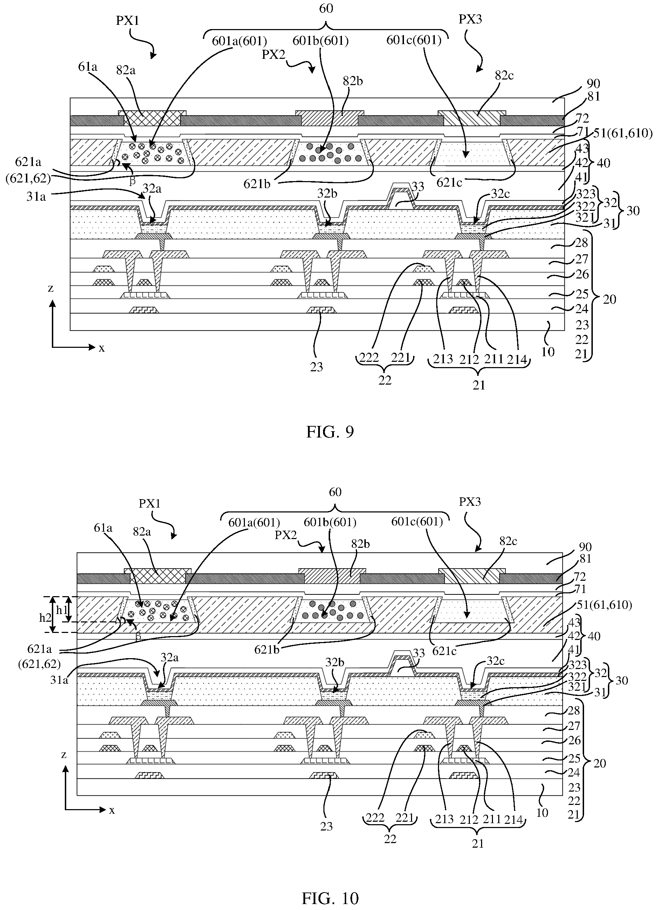

In some embodiments, as shown in FIG. 9, the first opening 61a penetrates through the dam layer 61, the material of the dam layer 61 includes a light-transmitting material, and the dam layer 61 may be the organic material layer 51. In the present embodiment, a region between the color conversion portions 601 in the color conversion layer 60 may be defined by the second light-blocking layer 81 while the dam layer 61 is made of the light-transmitting material, so as to avoid the light crosstalk.

In some embodiments, as shown in FIG. 10, in the direction from the substrate 10 to the luminescent structure layer 30, a depth h1 of the first opening 61a is smaller than a maximum thickness h2 of the dam layer 61, and the material of the dam layer 61 includes a light-transmitting material. The side of the second inorganic encapsulation layer 43 away from the substrate 10 is protected by the dam layer 61, so that the second inorganic encapsulation layer 43 is prevented from being damaged by over-etching in the manufacturing process, and the water vapor isolation of the display panel is improved.

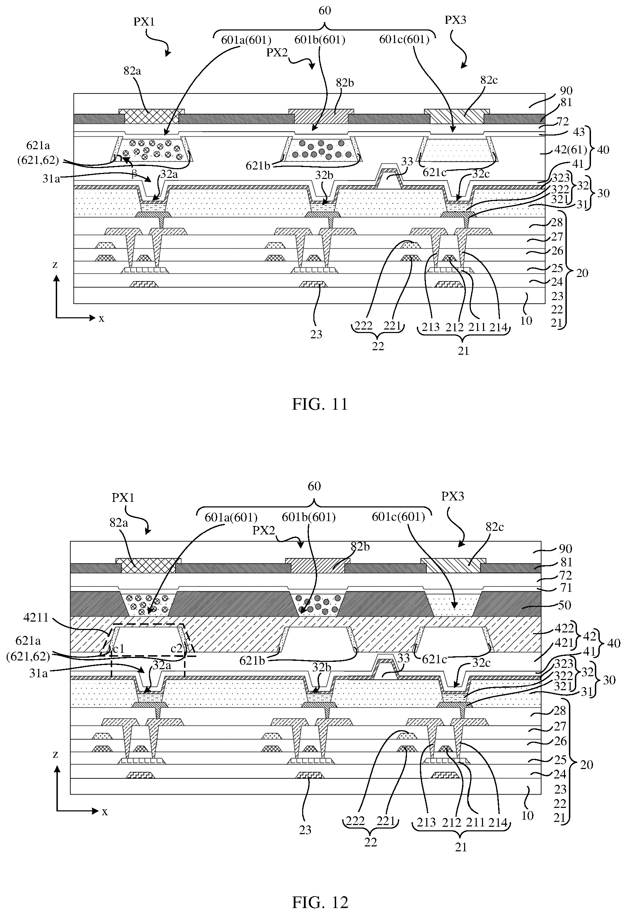

In some embodiments, as shown in FIG. 11, the display panel further includes an encapsulation layer 40 on a side of the luminescent structure layer 30 away from the substrate 10, and the encapsulation layer 40 includes an organic encapsulation layer 42 which is further used as the dam layer 61.

In this embodiment, the organic encapsulation layer 42 is further used as the dam layer 61, that is, the organic encapsulation layer 42 and the dam layer 61 have a one-piece structure, so that the space in the organic encapsulation layer 42 may be used to form the color conversion layer 60 and the reflective layer 62, and a thickness of the entire display panel can be further reduced.

In some embodiments, as shown in any one of FIGS. 8 to 11, the second planarization layer 72 is provided on a side of the second encapsulation layer 40 away from the substrate 10, to form a flat surface, which is advantageous for further forming the second light-blocking layer 81 and the color filter layer 82.

In some embodiments, as shown in any one of FIGS. 8 to 11, a smaller angle β of inclination angles of sidewalls of the first opening is greater than or equal to 45° and less than 90°, that is, the reflective element 621 is provided with a reflective surface close to one side of the corresponding one of the light-emitting units 32a, 32b and 32c, and an angle between the reflective surface and a light-outgoing surface of the corresponding one of the light-emitting units 32a, 32b and 32c is greater than or equal to 45° and less than 90°. Therefore, the reflected light is more easily emitted into the color conversion portions 601 to excite more quantum dots, and the color conversion efficiency and the light utilization efficiency can be improved.

In some embodiments, as shown in any one of FIGS. 12 to 20, the display panel further includes an encapsulation layer 40 arranged on a side of the luminescent structure layer 30 away from the substrate 10, the encapsulation layer 40 includes the organic encapsulation layer 42, and the reflective layer 62 is located within the organic encapsulation layer 42.

In the present embodiment, the reflective layer 62 is disposed within the organic encapsulation layer 42, so that the space in the organic encapsulation layer 42 may be utilized, and the thickness of the whole display panel can be further reduced by using the structure of the organic encapsulation layer 42 as a carrier for forming the reflective element 621.

In some embodiments, as shown in FIG. 12, the organic encapsulation layer 42 includes a first organic encapsulation layer 421 located on a side of the luminescent structure layer 30 away from the substrate 10, the first organic encapsulation layer 421 is provided with a plurality of first protrusions 4211 arranged at intervals, and an orthographic projection of each first protrusion 4211 on the substrate 10 covers an orthographic projection of one color conversion portion 601 on the substrate 10; a cross section of the first protrusion 4211 gradually decreases in the direction from the substrate 10 to the luminescent structure layer 30, the cross section is perpendicular to a surface of the substrate 10 close to the luminescent structure layer 30; each reflective element 621 is arranged on a sidewall of a corresponding first protrusion 4211.

In this embodiment, by disposing the first organic encapsulation layer 421 having the first protrusions 4211 in the organic encapsulation layer 42, the reflective element 621 with a corresponding inclination angle may be formed on the sidewall of the first organic encapsulation layer 421, so as to meet the requirement that light is emitted from the light-emitting units 32a, 32b and 32c into the reflective elements 621 and then reflected to the corresponding color conversion portions 601.

In some embodiments, the orthographic projection of the first protrusion 4211 on the substrate 10 covers the orthographic projection of the corresponding one of the light-emitting units 32a, 32b and 32c on the substrate, a region enclosed by an orthographic projection of each of the first reflective element 621a, the second reflective element 621b and the third reflective element 621c on the substrate 10 covers the orthographic projection of the corresponding one of the light-emitting units 32a, 32b and 32c on the substrate 10; the orthographic projection of each of the first reflective element 621a, the second reflective element 621b and the third reflective element 621c on the substrate 10 has a ring shape, and further, the orthographic projection of the first protrusion 4211 on the substrate 10 covers an orthographic projection of a region covered by the light emitted by the corresponding one of the light-emitting units 32a, 32b and 32c to a surface of the first protrusion 4211 close to the substrate 10 on the substrate 10. Therefore, the light emitted from the light-emitting units 32a, 32b and 32c may be fully reflected by the reflective elements 621 and then incident into the corresponding color conversion portions 601 for use. In some examples, as shown in FIG. 12, the light with the maximum angle emitted by the first light-emitting unit 32a is incident to two intersection points c1 and c2 on the cross-sectional view of a surface of the first protrusion 4211 away from the substrate 10, and the two intersection points c1 and c2 are boundary points, which are close to the first light-emitting unit 32a, of the first protrusion 4211 corresponding to the first light-emitting unit 32a on the cross section.

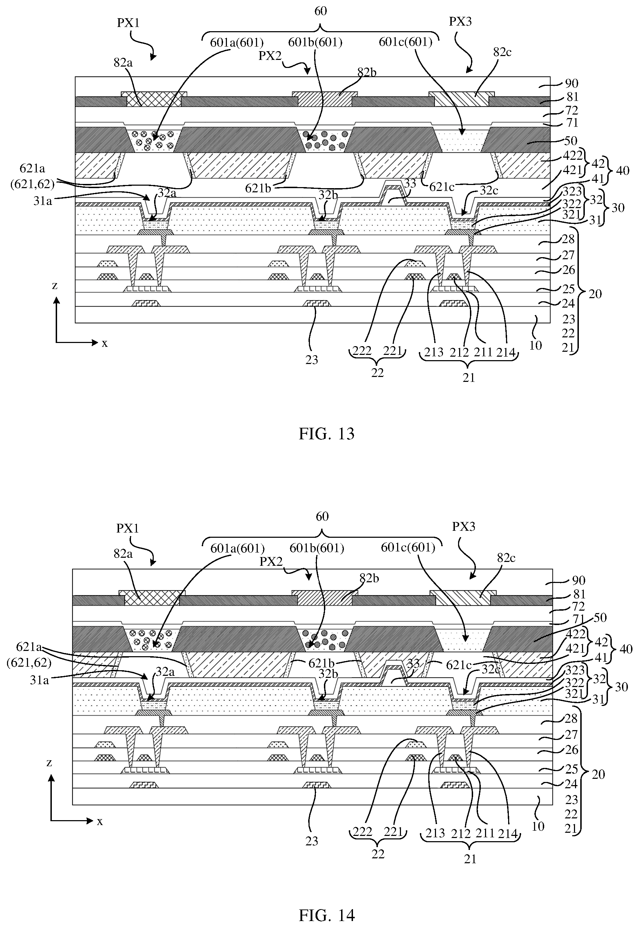

In some embodiments, as shown in FIG. 12 or 13, the display panel further includes a second organic encapsulation layer 422 on a side of the first organic encapsulation layer 421 away from the substrate 10, and a surface of each color conversion portion 601 close to the substrate 10 is in contact with the first organic encapsulation layer 421 or the second organic encapsulation layer 422.

In the present embodiment, the second organic encapsulation layer 422 is disposed to perform a planarization process after the reflective layer 62 is formed, so as to maintain the relative flatness of the layer when the color conversion layer 60 is formed subsequently.

In some examples, as shown in FIG. 12, the display panel further includes the second organic encapsulation layer 422 on a side of the first organic encapsulation layer 421 away from the substrate 10, and the surface of each color conversion portion 601 close to the substrate 10 is in contact with the second organic encapsulation layer 422. A surface of the second organic encapsulation layer 422 away from the substrate 10 is substantially planar.

In some examples, as shown in FIG. 13, the display panel further includes the second organic encapsulation layer 422 on a side of the first organic encapsulation layer 421 away from the substrate 10, and the surface of each color conversion portion 601 close to the substrate 10 is in contact with the first organic encapsulation layer 421. The second organic encapsulation layer 422 is completely filled in a recess of the first organic encapsulation layer 421.

In some embodiments, as shown in FIG. 14, the display panel further includes the second organic encapsulation layer 422 located on the same side of the luminescent structure layer 30 as the first organic encapsulation layer 421, and the second organic encapsulation layer 422 is in contact with the first inorganic encapsulation layer 41. In this embodiment, the first organic encapsulation layer 421 and the second organic encapsulation layer 422 are disposed in the same layer, so that the overall thickness of the display panel can be further reduced, and the display panel can be made thinner and lighter.

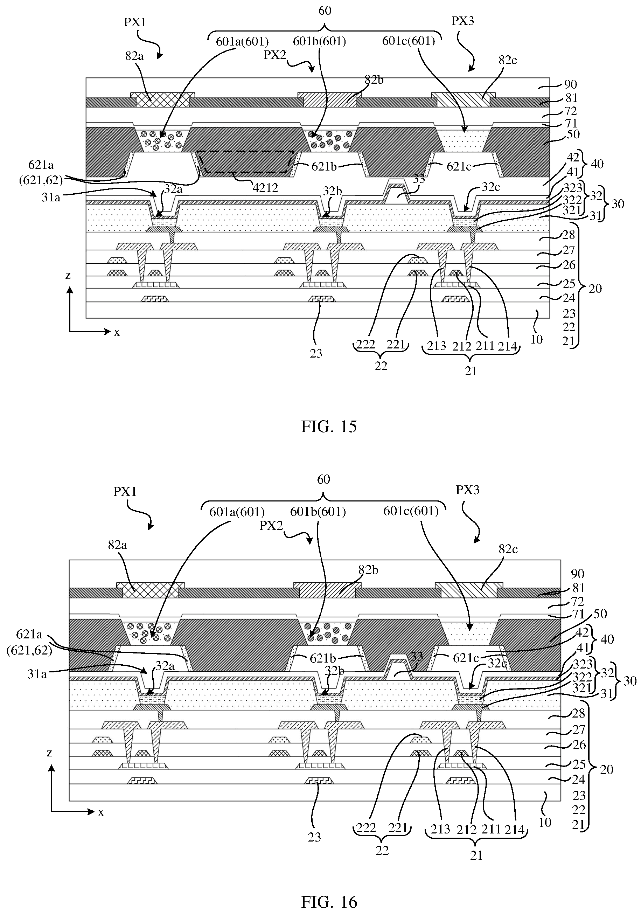

In some embodiments, as shown in FIG. 15, the first organic encapsulation layer 421 has a recess 4212, an orthographic projection of the recess on the substrate 10 does not overlap with the orthographic projection of the first protrusion on the substrate 10, the first light-blocking layer 50 is further provided on a side of the first organic encapsulation layer 421 away from the substrate 10, and at least a portion of the first light-blocking layer 50 is located in the recess 4212.

In this embodiment, the first light-blocking layer 50 is directly filled in the recess 4212, which can omit the formation of the second organic encapsulation layer 422, thereby further reducing the number of times of using a mask in the manufacturing process, reducing the material cost, simplifying the process steps, and improving the manufacturing efficiency.

In some embodiments, as shown in FIG. 16, the display panel further includes the first inorganic encapsulation layer 41 on a side of the organic encapsulation layer 42 close to the substrate 10, and the first light-blocking layer 50 is in contact with the first inorganic encapsulation layer 41.

In this embodiment, the first organic encapsulation layer 421 is further thinned to make the display panel thinner and lighter.

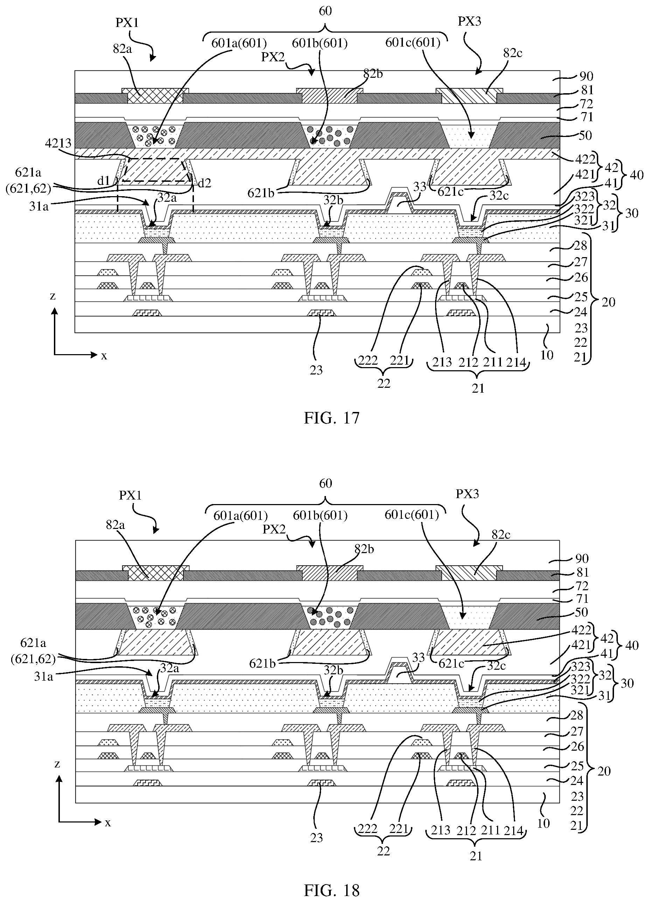

In some embodiments, as shown in FIG. 17, the organic encapsulation layer 42 includes the first organic encapsulation layer 421 located on a side of the luminescent structure layer 30 away from the substrate 10, the first organic encapsulation layer 421 is provided with a plurality of third openings 4213 arranged at intervals, and an orthographic projection of each third opening 4213 on the substrate 10 covers an orthographic projection of one color conversion portion 601 on the substrate 10; a cross section of each third opening 4213 has a trapezoid shape in the direction from the substrate 10 to the luminescent structure layer 30, and each of the reflective elements 621 is arranged on a sidewall of a corresponding third opening 4213.

Similar to the previous embodiments, in the present embodiment, the first organic encapsulation layer 421 is included, and the third openings 4213 are arranged in the first organic encapsulation layer 421, so that the reflective element 621 may be formed on a sidewall of each third opening 4213, so as to improve the light utilization efficiency.

In some embodiments, an orthographic projection of a surface of each third opening 4213 close to the substrate 10 on the substrate 10 covers an orthographic projection of the corresponding one of the light-emitting units 32a, 32b and 32c on the substrate 10, a region enclosed by the orthographic projection of each of the first reflective element 621a, the second reflective element 621b and the third reflective element 621c on the substrate 10 covers the orthographic projection of the corresponding one of the light-emitting units 32a, 32b and 32c on the substrate 10, and the orthographic projection of each of the first reflective element 621a, the second reflective element 621b and the third reflective element 621c on the substrate 10 has a ring shape. Further, the orthographic projection of each third opening 4213 on the substrate 10 covers an orthographic projection of a region covered by the light emitted by the corresponding one of the light-emitting units 32a, 32b and 32c to a surface of the third opening 4213 close to the substrate 10 on the substrate 10. Therefore, the light emitted from the light-emitting units 32a, 32b and 32c may be fully reflected by the reflective elements 621 and then incident into the corresponding color conversion portions 601 for use. In some examples, as shown in FIG. 17, the light with the maximum angle emitted by the first light-emitting unit 32a is incident to two intersection points d1 and d2 on the cross-sectional view of a surface of the third opening 4213 away from the substrate 10, and the two intersection points d1 and d2 are boundary points, which are close to the first light-emitting unit 32a, of the third opening 4213 corresponding to the first light-emitting unit 32a on the cross section.

In some embodiments, as shown in FIGS. 17 and 18, the display panel further includes the second organic encapsulation layer 422 on a side of the first organic encapsulation layer 421 away from the substrate 10, the first light-blocking layer 50 is further provided on a side of the organic encapsulation layer 42 away from the substrate 10, and a surface of the first light-blocking layer 50 close to the substrate 10 is in contact with the first organic encapsulation layer 421 or the second organic encapsulation layer 422.

In some embodiments, as shown in FIG. 17, the surface of the first light-blocking layer 50 close to the substrate 10 is in contact with the second organic encapsulation layer 422.

In some embodiments, as shown in FIG. 18, the surface of the first light-blocking layer 50 close to the substrate 10 is in contact with the first organic encapsulation layer 421.

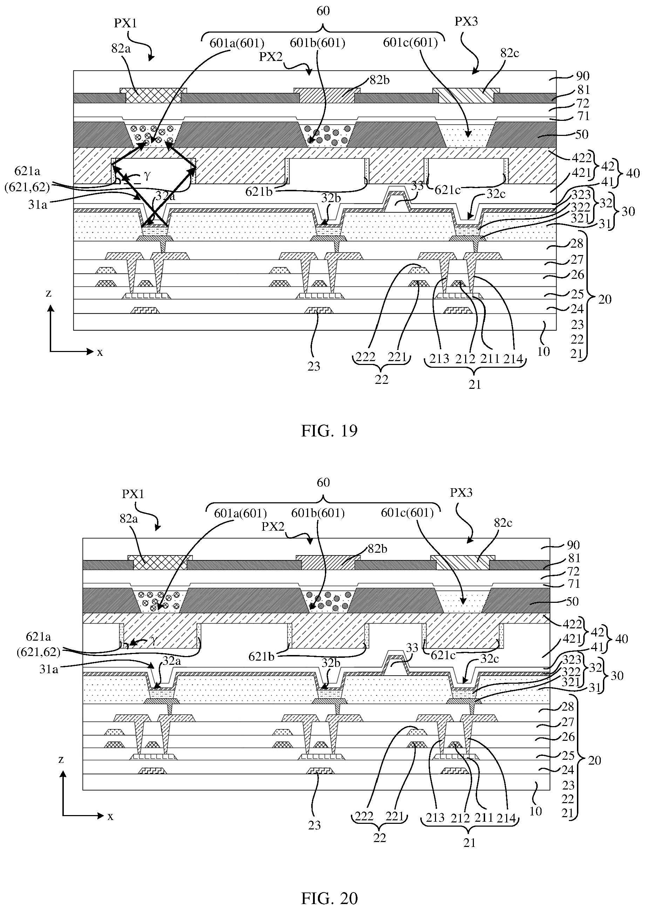

In some embodiments, as shown in FIG. 19 or FIG. 20, when the reflective layer 62 is arranged between the luminescent structure layer 30 and the color conversion layer 60, an extending direction of each of the plurality of reflective elements 621 of the reflective layer 62 and an extending direction of the light-outgoing surface of the corresponding one of the light-emitting units 32a, 32b, and 32c may be perpendicular to each other, that is, an angle γ between a reflective surface of the reflective element 621 close to the corresponding light-emitting unit and the plane where the substrate 10 is located may be about 90°, as long as the light emitted by the light-emitting units 32a, 32b, and 32c is reflected by the reflective elements 621 and then may be incident into the color conversion portions 601.

It is noted that the term "about" and similar terms as used in the present disclosure are used as approximate terms and not as degree terms, and are intended to provide a margin for inherent variations in measured or calculated values that would be recognized by one of ordinary skill in the art. For example, in the present disclosure, the expression "the angle γ may be about 90°" may be understood as the angle γ may be in a range from 85° to 95°, and specifically may be 85°, 86°, 87°, 88°, 89°, 90°, 91°, 92°, 93°, 94°, or 95°.

Based on the same inventive concept, the present disclosure further provides a display device, which includes the display panel in the foregoing embodiments and a housing. It should be noted that the display device may be any apparatus that displays images, moving (e.g., video) or stationary (e.g., still image), or textual content. For example, the display device may include a portable electronic device such as a mobile phone, a smart phone, a tablet personal computer (PC), a mobile communication terminal, an electronic notebook, an electronic book, a portable multimedia player, a navigation device, and an ultra-mobile PC as well as a television, a notebook computer, a monitor, an advertising panel, and an Internet of things device. The display device may further be used in a wearable device such as a smart watch, a watch phone, and an eyeglass display. The display device may further be used as a dashboard, a central fascia, or a central information display (CID) of the dashboard in a vehicle, an indoor mirror display replacing a side mirror of the vehicle, and a display arranged or disposed on a rear side of a front seat to serve as an entertainment device for rear seat passengers in the vehicle.

Based on the same inventive concept, the present disclosure further provides a method for manufacturing a display panel, in combination with FIG. 3, including steps 100 to 500:
Step 100 includes: forming a dam layer film on a side of a luminescent structure layer 30 away from a substrate 10, and patterning the dam layer film to form a dam layer 61; the dam layer 61 is provided with a plurality of dam patterns 610 and a plurality of first openings 61a defined by the dam patterns 610 and arranged at intervals, the dam layer 61 is further provided with a plurality of second openings 61b, each second opening 61b is located between two adjacent first openings 61a, and a cross section of each second opening 61b of the dam pattern 610 has an inverted trapezoid shape in a direction from the substrate 10 to the luminescent structure layer 30;
Step 200 includes: forming a reflective layer 62 on sidewalls of the dam patterns 610 and the second openings 61b;
Step 300 includes: forming a color conversion layer 60 in the first openings 61a of the dam layer 61;
Step 400 includes: forming a third inorganic encapsulation layer 71 on a side of the dam layer 61 and the color conversion layer 60 away from the substrate 10; and
Step 500 includes: forming a first light- blocking layer 50 on a side of the third inorganic encapsulation layer 71 away from the substrate 10.

In this embodiment, a carrying surface capable of forming the reflective layer 62 may be provided by forming the dam layer 61 firstly, so as to form a plurality of reflective elements 621 in the reflective layer 62.

Based on the same inventive concept, the present disclosure further provides another method for manufacturing a display panel, in combination with FIG. 8, including steps 100 to 400:
Step 100 includes: forming a first light-blocking layer 50 on a side of a luminescent structure layer 30 away from a substrate 10, the first light-blocking layer 50 including a plurality of first openings 61a arranged at intervals; a cross section of each first opening 61a has a trapezoid shape in a direction from the substrate 10 to the luminescent structure layer 30;
Step 200 includes: forming a reflective layer 62 on sidewalls of the first openings 61a;
Step 300 includes: filling a color conversion portion 601 in each first opening 61a; and
Step 400 includes: forming a third inorganic encapsulation layer 71 on a side of the first light-blocking layer 50 and the color conversion portion 601 away from the substrate 10.

In the embodiment, the first light-blocking layer 50 is directly used as a carrying surface structure for forming the reflective layer 62, so that the manufacturing steps are simpler, and the process can be further simplified.

Based on the same inventive concept, the present disclosure further provides another method for manufacturing a display panel, in combination with FIG. 12, including steps 100 to 400:
Step 100 includes: forming a first organic encapsulation layer 421 on a side of a luminescent structure layer 30 away from a substrate 10, where the first organic encapsulation layer 421 is provided with a plurality of first protrusions 4211 arranged at intervals; a cross section of each first protrusion 4211 gradually decreases in a direction from the substrate 10 to the luminescent structure layer 30, the cross section is perpendicular to a surface of the substrate 10 close to the luminescent structure layer 30;
Step 200 includes: forming a reflective layer 62 on sidewalls of the first protrusions 4211;
Step 300 includes: forming a second organic encapsulation layer 422 on a side of the reflective layer 62 away from the substrate 10; and
Step 400 includes: sequentially forming a first light-blocking layer 50 and a color conversion layer 60 on a side of the second organic encapsulation layer 422 away from the substrate 10; an orthographic projection of each first protrusion 4211 on the substrate 10 covers an orthographic projection of one color conversion portion 601 on the substrate 10.

In the present embodiment, the reflective layer 62 is provided in the organic encapsulation layer 42, so that the overall thickness of the display panel can be further reduced, and the positions of the reflective elements 621 of the reflective layer 62 are no longer limited by the position of the first light-blocking layer 50, and therefore are more flexible.

Based on the same inventive concept, the present disclosure further provides another method for manufacturing a display panel, in combination with FIG. 15, including steps 100 to 400:
Step 100 includes: forming a first organic encapsulation layer 421 on a side of a luminescent structure layer 30 away from a substrate 10; the first organic encapsulation layer 421 is provided with a plurality of third openings 4213 arranged at intervals, and each third opening 4213 is arranged in a tapered manner in a direction from the substrate 10 to the luminescent structure layer 30.
Step 200 includes: forming a reflective layer 62 on sidewalls of the third openings 4213;
Step 300 includes: forming a second organic encapsulation layer 422 on a side of the reflective layer 62 away from the substrate 10; and
Step 400 includes: sequentially forming a first light-blocking layer 50 and a color conversion layer 60 on a side of the second organic encapsulation layer 422 away from the substrate 10.

Like the previous embodiments, in this embodiment, the reflective layer 62 may be disposed in the organic encapsulation layer 42, so that the thickness of the whole display panel can be further reduced, and the positions of the reflective elements 621 of the reflective layer 62 are no longer limited by the position of the first light-blocking layer 50, and therefore are more flexible.

It should be understood that the embodiments described herein should be considered in a descriptive sense only and not for purposes of limitation. Descriptions of features or aspects within each embodiment should generally be considered as available for other similar features or aspects in other embodiments. While one or more embodiments have been described with reference to the accompanying drawings, it will be understood by one of ordinary skill in the art that various changes in form and details may be made therein without departing from the spirit and scope defined by the claims, and equivalents thereof.

## Claims

1. A display panel, comprising:
a substrate;
a luminescent structure layer arranged on one side of the substrate and comprising a plurality of light-emitting units arranged at intervals;
a color conversion layer arranged on a side of the luminescent structure layer away from the substrate and comprising a plurality of color conversion portions arranged at intervals, wherein an orthographic projection of each color conversion portion on the substrate covers an orthographic projection of a corresponding light-emitting unit of the plurality of light-emitting units on the substrate; and
a reflective layer arranged on a same side of the luminescent structure layer as the color conversion layer and comprising a plurality of reflective elements, wherein each reflective element is arranged corresponding to one light-emitting unit, an extending direction of each reflective element intersects an extending direction of a plane where the substrate is located, and at least a part of light emitted by each light-emitting unit is irradiated to its corresponding reflective element to be reflected to the color conversion portion corresponding to this light-emitting unit.

2. The display panel of claim 1, further comprising:
a dam layer, wherein the dam layer and the reflective layer are arranged on a same side of the luminescent structure layer, the dam layer comprises a plurality of dam patterns, and a plurality of first openings defined by the plurality of dam patterns and arranged at intervals, each first opening is filled with at least a part of one corresponding color conversion portion of the plurality of color conversion portions, the plurality of dam patterns are further provided with a plurality of second openings, every two adjacent first openings is provided with one second opening therebetween, a cross section of each second opening of the plurality of dam patterns has an inverted trapezoid shape in a direction from the substrate to the luminescent structure layer, and each reflective element is arranged on a sidewall between a dam pattern of the plurality of dam patterns corresponding to this reflective element and a corresponding second opening of the plurality of second openings corresponding to this reflective element.

3. The display panel of claim 2, wherein a region enclosed by an orthographic projection of each reflective element on the substrate covers an orthographic projection of its corresponding light-emitting unit on the substrate, and the orthographic projection of each reflective element on the substrate has a ring shape.

4. The display panel of claim 2, wherein the luminescent structure layer further comprises a pixel defining layer, the pixel defining layer is provided with a plurality of pixel openings, each light-emitting unit is located in a corresponding pixel opening of the plurality of pixel openings, and an orthographic projection of a surface of each first opening close to the substrate on the substrate covers an orthographic projection of an opening surface of its corresponding pixel opening away from the substrate on the substrate.

5. The display panel of claim 2, wherein the display panel further comprises an inorganic encapsulation layer and an organic material layer sequentially stacked on a side of the reflective layer away from the substrate, and a material of the organic material layer is at least one of a light-transmitting material and a light-shielding material.

6. The display panel of claim 1, wherein the display panel further comprises:
a dam layer, wherein the dam layer and the reflective layer are arranged on a same side of the luminescent structure layer, the dam layer comprises a plurality of dam patterns, and a plurality of first openings defined by the plurality of dam patterns and arranged at intervals, each first opening is filled with at least a part of one corresponding color conversion portion of the plurality of color conversion portions, a cross section of each first opening has a trapezoid shape in a direction from the substrate to the luminescent structure layer, and each reflective element is arranged on a sidewall of a corresponding first opening of the plurality of first openings.

7. The display panel of claim 6, wherein each reflective element is in contact with a corresponding color conversion portion of the plurality of color conversion portions.

8. The display panel of claim 6, wherein an orthographic projection of a surface, close to the substrate, of each first opening on the substrate covers an orthographic projection of its corresponding light-emitting unit on the substrate, a region enclosed by an orthographic projection of each reflective element on the substrate covers an orthographic projection of its corresponding light-emitting unit on the substrate, and the orthographic projection of each reflective element on the substrate has a ring shape.

9. The display panel of claim 6, wherein each first opening penetrates through the dam layer, and a material of the dam layer is at least one of a light-shielding material and a light-transmitting material; or
a depth of each first opening is smaller than a maximum thickness of the dam layer in the direction from the substrate to the luminescent structure layer, and a material of the dam layer is a light-transmitting material.

10. The display panel of claim 6, wherein the display panel further comprises an encapsulation layer arranged on a side of the luminescent structure layer away from the substrate, the encapsulation layer comprises an organic encapsulation layer, and the organic encapsulation layer is further used as the dam layer.

11. The display panel of claim 1, wherein the display panel further comprises an encapsulation layer located on a side of the luminescent structure layer away from the substrate, the encapsulation layer comprises an organic encapsulation layer, and the reflective layer is arranged in the organic encapsulation layer.

12. The display panel of claim 11, wherein the organic encapsulation layer comprises a first organic encapsulation layer arranged on a side of the luminescent structure layer away from the substrate, the first organic encapsulation layer is provided with a plurality of first protrusions arranged at intervals, and an orthographic projection of each first protrusion on the substrate covers an orthographic projection of its corresponding color conversion portion on the substrate; a cross section of each first protrusion is gradually reduced in a direction from the substrate to the luminescent structure layer, and the cross section is parallel to a surface of the substrate close to the luminescent structure layer; and each reflective element is arranged on a sidewall of a corresponding first protrusion of the plurality of first protrusions.

13. The display panel of claim 12, wherein the orthographic projection of each first protrusion on the substrate covers an orthographic projection of its corresponding light-emitting unit on the substrate, a region enclosed by an orthographic projection of each reflective element on the substrate covers an orthographic projection of its corresponding light-emitting unit on the substrate, and the orthographic projection of each reflective element on the substrate has a ring shape.

14. The display panel of claim 12, wherein the display panel further comprises a second organic encapsulation layer on a side of the first organic encapsulation layer away from the substrate, and a surface of each color conversion portion close to the substrate is in contact with the first organic encapsulation layer or the second organic encapsulation layer.

15. The display panel of claim 12, wherein the display panel further comprises a second organic encapsulation layer on a same side of the luminescent structure layer as the first organic encapsulation layer, and a first inorganic encapsulation layer on a side of the organic encapsulation layer close to the substrate, and the second organic encapsulation layer is in contact with the first inorganic encapsulation layer.

16. The display panel of claim 12, wherein the first organic encapsulation layer comprises a recess, an orthographic projection of the recess on the substrate does not overlap with an orthographic projection of each first protrusion on the substrate, the display panel further comprises a first light-blocking layer arranged on a side of the first organic encapsulation layer away from the substrate, and at least a part of the first light-blocking layer is within the recess.

17. The display panel of claim 16, further comprising a first inorganic encapsulation layer on a side of the organic encapsulation layer close to the substrate, wherein the first light-blocking layer is in contact with the first inorganic encapsulation layer.

18. The display panel of claim 11, wherein the organic encapsulation layer comprises a first organic encapsulation layer arranged on a side of the luminescent structure layer away from the substrate, the first organic encapsulation layer is provided with a plurality of third openings arranged at intervals, and an orthographic projection of each third opening on the substrate covers an orthographic projection of a corresponding color conversion portion on the substrate; and a cross section of each third opening has a trapezoid shape in a direction from the substrate to the luminescent structure layer, and each reflective element is arranged on a sidewall of a corresponding third opening of the plurality of third openings.

19. The display panel of claim 18, wherein an orthographic projection of each third opening on the substrate covers an orthographic projection of its corresponding light-emitting unit on the substrate, a region enclosed by an orthographic projection of each reflective element on the substrate covers an orthographic projection of its corresponding light-emitting unit on the substrate, and the orthographic projection of each reflective element on the substrate has a ring shape.

20. The display panel of claim 18, wherein the display panel further comprises a second organic encapsulation layer arranged on a side of the first organic encapsulation layer away from the substrate, and a first light-blocking layer arranged on a side of the organic encapsulation layer away from the substrate, and a surface of the first light-blocking layer close to the substrate is in contact with the first organic encapsulation layer or the second organic encapsulation layer.

21. The display panel of any one of claims 1 to 20, wherein a material of each reflective element is a metal.

22. The display panel of any one of claims 1 to 20, wherein each reflective element comprises a reflective surface close to one side of its corresponding light-emitting unit, and an angle between the reflective surface and a light-outgoing surface of the corresponding light-emitting unit is less than 90°.

23. The display panel of any one of claims 1 to 20, wherein each reflective element comprises a reflective surface close to one side of its corresponding light-emitting unit, and an angle between the reflective surface and a light-outgoing surface of the corresponding light-emitting unit is greater than or equal to 45°.

24. The display panel of any one of claims 1 to 20, wherein at least one of the plurality of color conversion portions comprises quantum dots and scatters.

25. A display device, comprising the display panel of any one of claims 1 to 24.
